# EUROPEAN PATENT SPECIFICATION

(11) **EP 2 180 536 B1**
(45) Date of publication and mention of the grant of the patent: **02.04.2014**
(21) Application number: 09174027.4
(22) Date of filing: 26.10.2009
(51) Int. Cl.: H01L 27/32, H01L 51/52

(54) **Organic light emitting diode display**
Organische lichtemittierende Diodenanzeige
Affichage à diode électroluminescente organique

(30) Priority: 24.10.2008 KR 20080104868
(43) Date of publication of application: 28.04.2010
(73) Proprietor: Samsung Display Co., Ltd., Yongin-City, Gyeonggi-Do, 446-711 (KR)
(72) Inventor: Yee, Dong-Su, Yongin-city, Gyunggi-do (KR); Cho, Dai-Han, Yongin-city, Gyunggi-do (KR); Hwang, Jung-Ho, Yongin-city, Gyunggi-do (KR); Moon, Chan-Kyoung, Yongin-city, Gyunggi-do (KR); Lee, Hyun-Hee, Yongin-city, Gyunggi-do (KR); Kim, Min-Su, Yongin-city, Gyunggi-do (KR); Wang, Chan-Hee, Yongin-city, Gyunggi-do (KR)
(74) Representative: Gulde Hengelhaupt Ziebig & Schneider

(56) References cited:
- JP-A- 2006 154 383
- US-A- 5 929 950
- US-A1- 2007 076 138

## Description

### BACKGROUND

The field invention relates to an organic light emitting diode (OLED) display and, more particularly, to an OLED display with improved impact resistance and assembling efficiency.

### Description of the Related Technology

Unlike a liquid crystal display (LCD), an OLED display has self-emission characteristics, so it does not need a light source. Thus, it is thinner and lighter. In addition, the OLED display exhibits quality characteristics such as low power consumption, high luminance, high response speed, and as such, the OLED display receives much attention as a next-generation display device for mobile electronic display devices.

In general, the OLED display includes two attached substrates, having there between a display panel assembly with organic light emitting elements, a printed circuit board (PCB) electrically connected with the display panel assembly through a flexible printed circuit (FPC), and a support member or a bezel supporting the display panel assembly, the PCB, or the like. Accordingly, the display panel assembly on the support member, and the PCB is disposed on a rear surface of the support member.

The display panel assembly, the PCB, and the support member are part of a single module that is received in the interior of a case. The case may be a separate case, or may be a case of an electronic device for which the OLED display is used.

Unlike the LCD in which a structure such as a backlight unit or the like is positioned between the display panel assembly and the support member (cf. for example US 2007/0076138 A1; JP 2006 154383; US 5,929,950), the OLED display does not have any structure between the display panel assembly and the support member. Thus, the OLED display is weak to external impact such as a drop impact or the like.

In addition, the OLED display having the support member may have weaker impact resistance than that of an OLED display that does not have such a support member. One of the reasons is that the support member may be deformed and impact or collide with the display panel assembly and damage it.

Thus, the support member may be omitted to seek enhancement of the impact resistance, but the omission of the support member severely degrades the assembling efficiency.

The above information disclosed in this Background section is only for enhancement of understanding of the background of the invention and therefore it may contain information that does not form the prior art that is already known in this country to a person of ordinary skill in the art.

### SUMMARY OF CERTAIN INVENTIVE EMBODIMENTS

The organic light emitting diode display according to the present invention is defined in claim 1.

The buffer is configured to absorb energy from an impact to device. Thus, the buffer member improves the impact resistance of the display.

Preferably, the buffer member may have a thickness ranging from 0.2mm to 0.5mm. In this way, the buffer member can sufficiently absorb an external impact.

Preferably, the buffer member may be spaced apart from the support member. Thus, an internal impact may not be transferred from the support member to the buffer member.

The buffer member may comprise an adhesive layer facing the display panel assembly or the buffer member may entirely consists of an adhesive material. This allows the display to be assembled more easily.

The support member may comprise a bottom part supporting the edges of the display panel assembly, and a side wall part formed to protrude from the bottom part. The bottom part of the support member and the edge of the display panel assembly may contact in an overlap area having a width ranging from 0.5mm to 1.0mm. The side wall part of the support member may be spaced apart from the display panel assembly. The side wall part may protrude from the bottom part at least as far as the far surface of the display panel assembly.

The support member may have a thickness ranging from 0.2mm to 0.5mm. The support member may be made of one or more of a resin-based material including polycarbonate, and a metal-based material comprising at least one of stainless steel, magnesium, aluminum, and an alloy thereof.

The display panel assembly may comprise an encapsulation substrate sealed to a display substrate. The display substrate may comprise a plurality of pixels configured to display an image.

The support member may comprise a connection part configured to receive a flexible printed circuit board.

### BRIEF DESCRIPTION OF THE DRAWINGS

FIG. 1 is an exploded perspective view of an organic light emitting diode (OLED) display according to one embodiment.
FIG. 2 is a cross-sectional view showing a coupled state of the OLED display in FIG. 1.
FIG. 3 is a circuit diagram showing a pixel circuit of a display panel assembly in FIG. 1.
FIG. 4 is a partially enlarged cross-sectional view of the display panel assembly in FIG. 1.

### DETAILED DESCRIPTION OF CERTAIN INVENTIVE EMBODIMENTS

Certain embodiments will be described more fully hereinafter with reference to the accompanying drawings. As those skilled in the art would realize, the described embodiments may be modified in various different ways, without departing from the scope of the present invention.

Some embodiments provide an organic light emitting diode (OLED) display having advantages of improving impact resistance and assembly efficiency, and reducing the overall thickness.

The scale, size, and thickness of each element are arbitrarily shown in the drawings, and the present invention is not limited thereto.

In the drawings, the thickness of layers, films, panels, regions, etc., may be exaggerated for clarity. Like reference numerals generally designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

In order to clarify the present invention, parts unrelated to descriptions may be omitted.

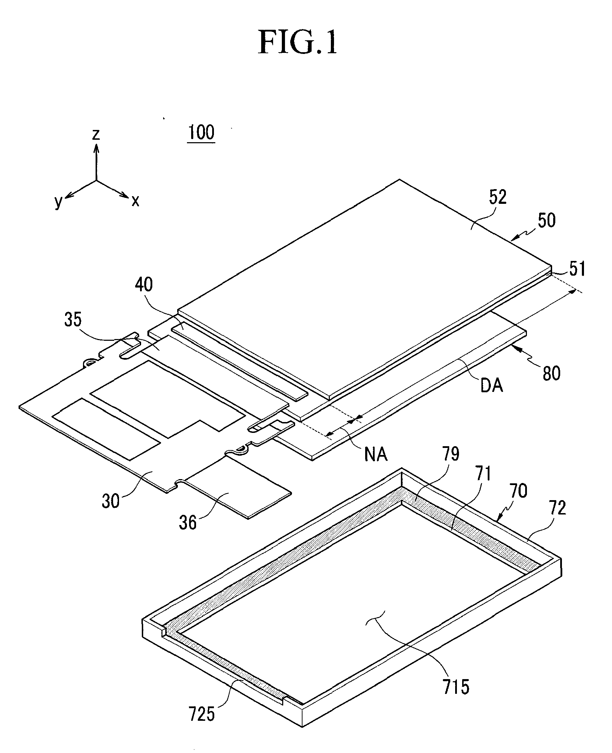

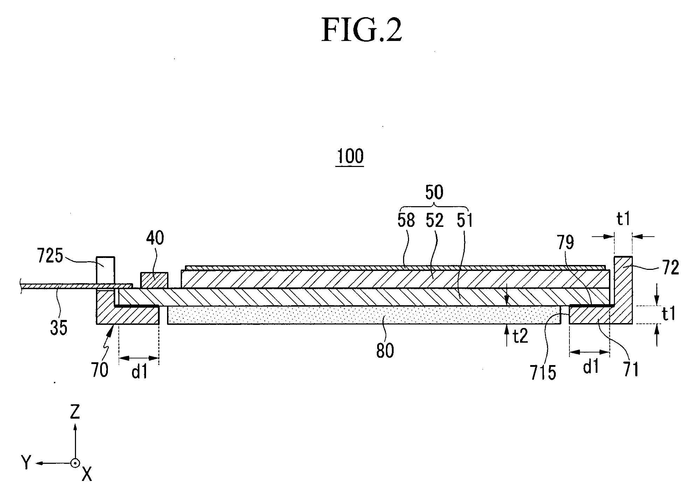

Exemplary embodiments of the present invention will now be described with reference to FIGs. 1 and 2. Embodiments with different configurations and arrangements may also be used.

As shown in FIG. 1, an organic light emitting diode (OLED) display 100 includes a display panel assembly 50, a support member 70, and a buffer member 80. The OLED display 100 further includes a printed circuit board (PCB) 30 and a flexible PCB (FPCB) 35.

The display panel assembly 50 includes a display substrate 51, an encapsulation substrate 52, and an integrated circuit (IC) chip 40. The display substrate 51 includes a display area (DA) and a mount area (namely, a non-display area (NA)). The encapsulation substrate 52 has a smaller size than the display substrate 51, and is attached to the display area of the display substrate 51. The display substrate 51 and the encapsulation substrate 52 are sealed by a sealant (not shown), which may be disposed along edges of the encapsulation substrate 52. The IC chip 40 is mounted on the mount area of the display substrate 51. The IC chip 40 is mounted on the same surface of the display substrate 51 on which the encapsulation substrate 51 is attached. Namely, the encapsulation substrate 52 and the IC chip 40 are disposed to be adjacent to each other.

Although not shown, in some embodiments, the display panel assembly 50 further includes a protection layer to cover the mount area (NA) to mechanically protect the IC chip 40 and prevent the mount area (NA) from being corroded.

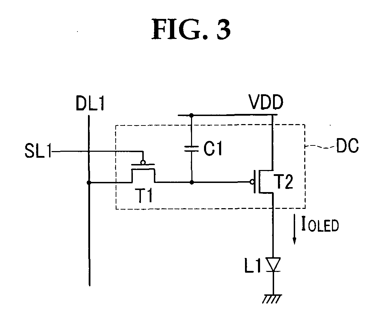

The display substrate 51 includes a plurality of pixels arranged in a matrix form at the display area (DA). As shown in the embodiment of FIG. 3, a single pixel includes an organic light emitting element L1, a plurality of thin film transistors (TFTs) T1 and T2, and one or more capacitor elements C1. Pixels of various other embodiments may also be used.

The display substrate 51 may further include a scan driver (not shown) and a data driver (not shown) to drive the pixels. The display substrate 51 further includes pad electrodes (not shown) disposed on the mount area (NA). In this embodiment, IC chip 40 is mounted in the form of chip-on-glass (COG) on the mount area (NA) of the display substrate 51 so as to be electrically connected with the pad electrodes (not shown). The display substrate 51 further includes wires (not shown) connecting the IC chip 40, the scan driver (not shown), and the data driver (not shown).

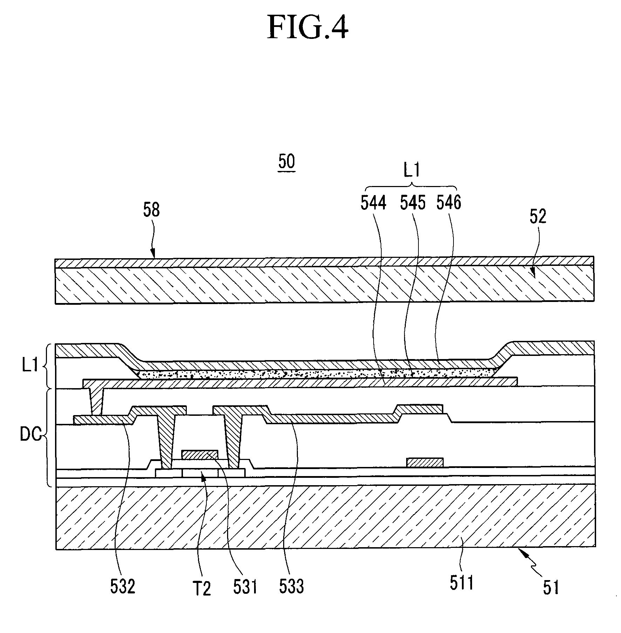

The encapsulation substrate 52 is attached to the display substrate 51 to seal and protect the organic light emitting element L1 (shown in FIG. 4), the TFT (T2) (shown in FIG. 4), various wires, and other elements formed on the substrate 52.

In some embodiments, the display panel assembly 50 may further include a polarizer (shown in FIG. 2) attached to one or more surfaces of the encapsulation substrate 52 to restrain reflection of external light.

The PCB 30 includes electronic elements (not shown) for processing drive signals, and a connector part 36 for receiving an external signal. One side of the FPCB 35 is connected with the mount area (NA) of the display substrate 51, and the other side of the FPCB 35 is connected with the PCB 30. Namely, the FPCB 35 electrically connects the PCB 30 and the display panel assembly 50. Accordingly, drive signals generated from the PCB 30 are delivered to the IC chip 40 or the drivers of the display substrate 51 via the FPCB 35.

As shown in FIG. 2, the support member 70 includes a bottom part 71 and a side wall part 72 formed to protrude from the bottom part 71. The support member 70 may be made of one or more of a resin-based material including polycarbonate (PC), and a metal-based material including stainless steel (SUS), magnesium (Mg), aluminum (Al), and their alloys. In some embodiments, the support member 70 is made of stainless steel.

The support member 70 has a thickness within the range of about 0.2mm to about 0.5mm and has proper strength to protect the display panel assembly 50. Accordingly, the bottom part 71 and the side wall part 72 each have the thickness (t1) ranging from about 0.2mm to about 0.5mm. If the thickness t1 of the support member 70 is less than about 0.2mm, the support member 70 may not have sufficient strength, while if it is larger than about 0.5mm, the support member 70 may have excessive strength and could damage the display panel assembly 50. That is, the support member 70 preferably maintains flexural rigidity so as to not have excessive flexibility or rigidity. Also, if the thickness t1 of the support member is too large, it would affect the overall thickness of the OLED display 100, degrading quality of the external appearance of the product.

The bottom part 71 is in contact with the edges of the display panel assembly to support the display panel assembly 50, with an opening 715 exposing a portion of a rear surface of the display panel assembly 50. Accordingly, the bottom part 71 is formed as a flange or frame disposed along the circumference of the side wall part 72, and when the display panel assembly 50 and the support member 70 are combined, the bottom part 71 supports the edges of the display substrate 51 of the display panel assembly 50. Thus, the exposed portion of the rear surface of the display panel assembly 50 due to the opening 715 may be a portion other than portions of the bottom display substrate 51 where the bottom part is in contact with the display substrate 51. Here, the rear surface of the display panel assembly 50 refers to the opposite surface of the surface of the display substrate 51 facing the encapsulation substrate 52.

The portion where the edge of the display panel assembly 50 and the bottom part 71 of the support member 70 are in contact has a width ranging from about 0.5mm to about 1.0mm. That is, the length d1 of the portion where the bottom part 71 of the support member 70 and the edge of the display panel assembly 50 overlap is within the range of about 0.5mm to about 1.0mm.

If the length d1 of the portion where the bottom part 71 and the rear surface of the display panel assembly 50 overlap is less than about 0.5mm, the support member 70 could not stably support the display panel assembly 50. If the length d1 of the portion where the bottom part 71 and the rear surface of the display panel assembly 50 overlap is larger than about 1.0mm, impact resistance of the OLED display 100 could be worse than a case where the support member 70 is not provided.

The side wall part 72 surrounds at least a portion of the display panel assembly 50 where the display panel assembly 50 and the support member 70 are connected, and is separated from the edges of the display panel assembly 50. In other words, an empty gap is formed between the side wall part 72 and the display panel assembly 50. Because the side wall part 72 is separated from the edges of the display panel assembly 50, even if the support member 70 is deformed, the display panel assembly 50 and the side wall part 72 do not collide, so damage of the display panel assembly 50 can be avoided.

In addition, the side wall part 72 has a height that is the same as or higher than the thickness of the display panel assembly 50 supported by the support member 70. This is to allow the support member 70 to stably protect the display panel assembly 50 and improve the assembling efficiency.

The support member 70 includes a connection part 725 which may be formed by cutting away a portion of the side wall part 72 neighboring the mount area (NA) of the display substrate 51, allowing the FPCB 35 to be connected with the mount area (NA) of the display substrate 51.

The OLED display 100 further includes an adhesive member 79 disposed between the bottom part 71 of the support member 70 and the edges of the rear surface of the display panel assembly 50. The adhesive member 79 bonds the display panel assembly 50 and the support member 70 together. In a preferred embodiment, the adhesive member 79 does not extend beyond the support member 70, i.e. may have a thickness of d1 plus the thickness of the gap between the side wall part 72 and the display panel assembly 50 or less.

The buffer member 80 is attached to the rear surface of the display panel assembly 50 exposed through the opening 715 of the bottom part 71, and is configured to absorb energy from an impact to the OLED display 100. The buffer member 80 is made of rubber material so that the display panel assembly 50 may not be broken by an impact that may be applied to the buffer member 80. For example, the buffer member 80 may be made of sponge formed by foaming a rubber solution or urethane obtained by fabricating a rubber solution as a synthetic resin.

The buffer member 80 is arranged spaced apart from the support member 72. In this way, an impact on the support member 72 is not transferred to the buffer member 80 and vice versa. Thus, the impact resistance of the display is be improved. The buffer member 80 has a smaller size than the corresponding opening 751 and may be centered in the opening 751.

The buffer member 80 has a thickness t2 ranging from about 0.2mm to about 0.5mm. If the thickness t2 of the buffer member is less than 0.2mm, the buffer member 80 would not sufficiently buffer an external impact applied to the display panel assembly 50. If the thickness of the buffer member 80 is larger than 0.5mm, the overall thickness of the OLED display 100 would become thicker and degrade the quality of the external appearance.

The buffer member 80 may include a buffer layer and an adhesive layer. For example, the buffer member 80 may be formed in the form of a release film. However, the present invention is not limited thereto. Thus, in some embodiments, the buffer member 80 does not include the adhesive layer, and is attached to the rear surface of the display panel assembly 50 by means of an adhesive member, such as adhesive member 79 that adheres the support member 70 to the display panel assembly 50 as described above. In this case, the adhesive member 79 that adheres the support member 70 to the display panel assembly 50 and the adhesive member that adheres the display panel assembly 50 may be integrally formed. The buffer member 80 may be formed as a buffer layer having an adhesive force itself. In some embodiments, the buffer member 80 is formed of an adhesive material, and has an adhesive force itself as shown in FIG. 2.

With such a configuration, the impact resistance and assembling efficiency of the OLED display can be improved, and the overall thickness of the OLED display can be reduced.

That is, although the OLED display 100 is formed to be thinner, it can effectively prevent the display panel assembly 50 from being damaged even when an external impact is applied to the OLED display if the OLED display is, for example, dropped. In addition, the improvement of the assembling efficiency can lead to an increase in the productivity.

The internal structure of the display panel assembly 50 will now be described with reference to FIGs. 3 and 4, which illustrate a particular embodiment of a pixel. Other pixels may also be used.

As shown in FIGs. 3 and 4, a pixel includes the organic light emitting element L1 and the driving circuit units T1, T2, and C1. The organic light emitting element L1 and the driving circuit units T1, T2, and C1 are generally formed on the display substrate 51. That is, the display substrate 51 includes a substrate member 511, the driving circuit units T1, T2, and C1 formed on the substrate member 511, and the organic light emitting element L1.

The organic light emitting element L1 includes an anode electrode 544, an organic light emission layer 545, and a cathode electrode 546. In this embodiment, the pixel includes two TFTs T1 and T2, and a storage capacitor C1. The TFTs include a switching transistor T1 and a driving transistor T2.

The switching transistor T1 is connected with a scan line SL1 and a data line DL1, and transfers a data voltage, which is input from the data line DL1 according to a switching voltage inputted to the scan line SL1, to the driving transistor T2. The storage capacitor C1 is connected with the switching transistor T1 and a power source line VDD, and stores a voltage corresponding to the difference between the voltage received from the switching transistor T1 and a voltage supplied to the power source line VDD.

The driving transistor T2 is connected with the power source line VDD and the storage capacitor C1, and supplies an output current I_{OLED} approximately proportional to the square of the difference between the voltage stored in the storage capacitor C1 and a threshold voltage to the organic light emitting element L1. The organic light emitting element L1 emits light according to the output current I_{OLED}. The driving transistor T2 includes a source electrode 533, a drain electrode 532, and a gate electrode 531. The anode electrode 544 of the organic light emitting element L1 is connected to the drain electrode 532 of the driving transistor T2. The structure of the pixel may modified and is not limited to the example of Figures 3 and 4.

The encapsulation substrate 52 covers the display substrate 51 with the organic light emitting element L1 and the driving circuit units T1, T2, and C1 formed thereon. A polarizer 58 may be formed on the encapsulation substrate 52 to restrain reflection of external light. However the present invention is not limited thereto. That is, the polarizer 58 may be formed under the encapsulation substrate 52 or on the organic light emitting element L1, or may be omitted according to various embodiments.

While various practical exemplary embodiments have been described, it is to be understood that the invention is not limited to the disclosed embodiments, but, on the contrary, is intended to cover modifications within the scope of the appended claims.

## Claims

1. An organic light emitting diode (100) display device, comprising:
a display panel assembly (50); and
a support member (70) supporting edges of the display panel assembly (50) and having an opening (715) exposing a rear surface of the display panel assembly (50); **characterized in that**
a buffer member (80) is attached to the rear surface of the display panel assembly (50) through the opening (715) of the support member (70), the buffer member (80) being made of rubber.

2. The device of claim 1, wherein the support member (70) comprises a bottom part (71) supporting the edges of the display panel assembly (50), and a side wall part (72) formed to protrude from the bottom part (71).

3. The device of claim 2, wherein the bottom part (71) of the support member (70) and the edge of the display panel assembly (50) contact in an overlap area having a width ranging from 0.5mm to 1.0mm.

4. The device of claim 2 or 3, wherein the side wall part (72) of the support member (70) is spaced apart from the display panel assembly (50).

5. The device of any of claims 2 to 4, wherein the side wall part (72) protrudes from the bottom part (71) at least as far as the an uppermost surface of the display panel assembly (50).

6. The device of any of the previous claims, wherein the buffer member (80) has a thickness ranging from 0.2mm to 0.5mm.

7. The device of any of the previous claims, wherein the buffer member (80):
comprises an adhesive layer facing the display panel assembly (50), or
consists of an adhesive material.

8. The device of any of the previous claims, wherein the buffer member (80) is spaced apart from the support member (70).

9. The device of any of the previous claims, wherein the support member (70) has a thickness ranging from 0.2mm to 0.5mm.

10. The device of any of the previous claims, wherein the support member (70) is made of one or more of a resin-based material including polycarbonate, and a metal-based material comprising at least one of stainless steel, magnesium, aluminum, and an alloy thereof.

11. The device of any of the previous claims, wherein the display panel assembly (50) comprises an encapsulation substrate (52) attached to a display substrate (51).

12. The device of claim 11, wherein the display substrate (51) comprises a plurality of pixels configured to display an image.

13. The device of claim 12, wherein the display substrate comprises an integrated circuit, configured to send signals to the pixels.

14. The device of any of the previous claims, wherein the support member (70) comprises a connection part (725) configured to receive a flexible printed circuit board (35).

## Patentansprüche

1. Organische lichtemittierende Dioden (100)-Anzeigevorrichtung, aufweisend:
eine Anzeigetafelanordnung (50); und
ein Stützelement (70), das Ränder der Anzeigetafelanordnung (50) abstützt und eine Öffnung (715) aufweist, die eine Rückfläche der Anzeigetafelanordnung (50) freilegt; **dadurch gekennzeichnet, dass**
ein Pufferelement (80) durch die Öffnung (715) des Stützelements (70) hindurch an der Rückfläche der Anzeigetafelanordnung (50) befestigt ist, wobei das Pufferelement (80) aus Gummi ausgefiihrt ist.

2. Vorrichtung nach Anspruch 1, wobei das Stützelement (70) einen Bodenteil (71), der die Ränder der Anzeigetafelanordnung (50) abstützt, und einen Seitenwandteil (72), der ausgebildet ist, um aus dem Bodenteil (71) vorzuragen, aufweist.

3. Vorrichtung nach Anspruch 2, wobei der Bodenteil (71) des Stützelements (70) und der Rand der Anzeigetafelanordnung (50) in einem Überlappungsbereich, der eine Breite im Bereich von 0,5 mm bis 1,0 mm aufweist, miteinander in Kontakt stehen.

4. Vorrichtung nach Anspruch 2 oder 3, wobei der Seitenwandteil (72) des Stützelements (70) von der Anzeigetafelanordnung (50) beabstandet ist.

5. Vorrichtung nach einem der Ansprüche 2 bis 4, wobei der Seitenwandteil (72) aus dem Bodenteil (71) zumindest so weit wie eine oberste Fläche der Anzeigetafelanordnung (50) vorragt.

6. Vorrichtung nach einem der vorhergehenden Ansprüche, wobei das Pufferelement (80) eine Dicke im Bereich von 0,2 mm bis 0,5 mm aufweist.

7. Vorrichtung nach einem der vorhergehenden Ansprüche, wobei das Pufferelement (80):
eine Klebeschicht, die der Anzeigetafelanordnung (50) zugewandt ist, aufweist
oder
aus einem Klebematerial besteht.

8. Vorrichtung nach einem der vorhergehenden Ansprüche, wobei das Pufferelement (80) vom Stützelement (70) beabstandet ist.

9. Vorrichtung nach einem der vorhergehenden Ansprüche, wobei das Stützelement (70) eine Dicke im Bereich von 0,2 mm bis 0,5 mm aufweist.

10. Vorrichtung nach einem der vorhergehenden Ansprüche, wobei das Stützelement (70) aus einem oder mehreren eines Polycarbonat aufweisenden Materials auf Harzbasis und eines Materials auf Metallbasis, das zumindest eines von rostfreiem Stahl, Magnesium, Aluminium und einer Legierung derselben aufweist, besteht.

11. Vorrichtung nach einem der vorhergehenden Ansprüche, wobei die Anzeigetafelanordnung (50) ein Verkapselungssubstrat (52) aufweist, das an einem Anzeigesubstrat (51) befestigt ist.

12. Vorrichtung nach Anspruch 11, wobei das Anzeigesubstrat (51) eine Vielzahl von Pixeln aufweist, die konfiguriert sind, um ein Bild anzuzeigen.

13. Vorrichtung nach Anspruch 12, wobei das Anzeigesubstrat eine integrierte Schaltung aufweist, die konfiguriert ist, um Signale an die Pixel zu senden.

14. Vorrichtung nach einem der vorhergehenden Ansprüche, wobei das Stützelement (70) einen Verbindungsteil (725) aufweist, der konfiguriert ist, um eine flexible Leiterplatte (35) aufzunehmen.

## Revendications

1. Dispositif d'affichage à diode électroluminescente organique (100), comprenant :
un ensemble de panneau d'affichage (50) ; et
un élément de support (70) supportant des bords de l'ensemble de panneau d'affichage (50) et ayant une ouverture (715) exposant une surface arrière de l'ensemble de panneau d'affichage (50) ; **caractérisé en ce que** :
un élément formant tampon (80) est fixé sur la surface arrière de l'ensemble de panneau d'affichage (50) à travers l'ouverture (715) de l'élément de support (70), l'élément formant tampon (80) étant réalisé à partir de caoutchouc.

2. Dispositif selon la revendication 1, dans lequel l'élément de support (70) comprend une partie inférieure (71) supportant les bords de l'ensemble de panneau d'affichage (50), et une partie de paroi latérale (72) formée pour faire saillie de la partie inférieure (71).

3. Dispositif selon la revendication 2, dans lequel la partie inférieure (71) de l'élément de support (70) et le bord de l'ensemble de panneau d'affichage (50) sont en contact dans une zone de chevauchement ayant une largeur de l'ordre de 0,5 mm à 1,0 mm.

4. Dispositif selon la revendication 2 ou 3, dans lequel la partie de paroi latérale (72) de l'élément de support (70) est éloignée de l'ensemble de panneau d'affichage (50).

5. Dispositif selon l'une quelconque des revendications 2 à 4, dans lequel la partie de paroi latérale (72) fait saillie de la partie inférieure (71) au moins autant que la surface la plus haute de l'ensemble de panneau d'affichage (50).

6. Dispositif selon l'une quelconque des revendications précédentes, dans lequel l'élément formant tampon (80) a une épaisseur de l'ordre de 0,2 mm à 0,5 mm.

7. Dispositif selon l'une quelconque des revendications précédentes, dans lequel l'élément formant tampon (80) :
comprend une couche adhésive faisant face à l'ensemble de panneau d'affichage (50), ou
se compose d'un matériau adhésif.

8. Dispositif selon l'une quelconque des revendications précédentes, dans lequel l'élément formant tampon (80) est éloigné de l'élément de support (70).

9. Dispositif selon l'une quelconque des revendications précédentes, dans lequel l'élément de support (70) a une épaisseur de l'ordre de 0,2 mm à 0,5 mm.

10. Dispositif selon l'une quelconque des revendications précédentes, dans lequel l'élément de support (70) est réalisé avec un ou plusieurs éléments parmi un matériau à base de résine comprenant du polycarbonate, et un matériau à base de métal comprenant au moins l'un parmi l'acier inoxydable, le magnésium, l'aluminium et leur alliage.

11. Dispositif selon l'une quelconque des revendications précédentes, dans lequel l'ensemble de panneau d'affichage (50) comprend un substrat d'encapsulation (52) fixé sur un substrat d'affichage (51).

12. Dispositif selon la revendication 11, dans lequel le substrat d'affichage (51) comprend une pluralité de pixels configurés pour afficher une image.

13. Dispositif selon la revendication 12, dans lequel le substrat d'affichage comprend un circuit intégré, configuré pour envoyer des signaux aux pixels.

14. Dispositif selon l'une quelconque des revendications précédentes, dans lequel l'élément de support (70) comprend une partie de raccordement (725) configurée pour recevoir une carte de circuit imprimé (35) flexible.
